# EUROPEAN PATENT SPECIFICATION

(11) **EP 0 778 581 B1**
(45) Date of publication and mention of the grant of the patent: **14.08.2002**
(21) Application number: 96308879.4
(22) Date of filing: 06.12.1996
(51) Int. Cl.: G11C 16/04, H01L 27/115

(54) **Nonvolatile memory device**
Nichtflüchtige Speicheranordnung
Dispositif de mémoire non-volatile

(30) Priority: 07.12.1995 KR 9547449; 21.08.1996 KR 9634768
(43) Date of publication of application: 11.06.1997
(73) Proprietor: Samsung Electronics Co., Ltd., Suwon-city, Kyungki-do (KR)
(72) Inventor: Oh, Suk-young, Yongin-city, Kyungki-do (KR)
(74) Representative: Ertl, Nicholas Justin

(56) References cited:
- EP-A- 0 053 075
- EP-A- 0 085 550
- EP-A- 0 582 319
- WO-A-85/03162
- US-A- 4 628 487
- PAUL I SUCIU ET AL: "Cell model for E2PROM floating-gate memories" INTERNATIONAL ELECTRON DEVICES MEETING, 13 - 15 December 1982, pages 737-740, XP002074820 San Francisco, US

## Description

The present invention relates to a nonvolatile memory device, and in particular aspects, to a nonvolatile memory device with an improved data retention characteristic which prevents a data reading error during a reading operation.

Semiconductor memory devices are classified into volatile memory devices, in which information stored therein is erased when the power supply is interrupted, and nonvolatile memory devices, which retains information stored therein even when the power supply is interrupted. Nonvolatile memory devices may themselves be roughly classified into a read only memory (ROM) from which data can only be read, and an electrically erasable and programmable read only memory (EEPROM) in which the data contained therein can be changed by applying an electrical signal thereto. Generally, the nonvolatile EEPROM device includes a floating gate and a control gate.

Hereinafter, a conventional nonvolatile memory device will be described with reference to the appended drawings.

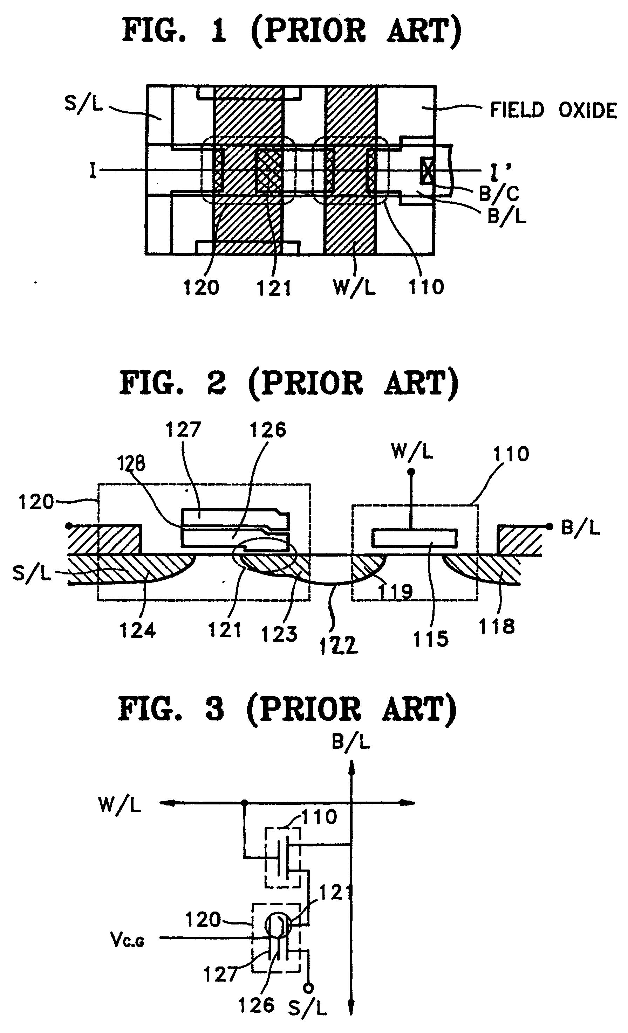

Fig. 1 shows a memory cell of a conventional EEPROM including a select transistor 110 and a storage transistor 120. The select transistor 110 selects a cell on an active line between a bit line B/L and a source line S/L. The storage transistor 120 has a tunnel window 121 for implanting electrons into a floating gate 126 (see Fig. 2) and for extracting electrons from the floating gate 126.

FIG. 2 shows a side view of the circuit of Fig.1 along the line I-I'. As shown in Fig 2, the select transistor 110 acts as a channel enhancement mode NMOS transistor and includes a drain area 118, a gate 115, and a source area 119. The drain area 118 is connected to the bit line B/L; the gate 115 is connected to the word line W/L; and the source area 119 is shared with a drain area 123 of the storage transistor 120 in a single doped region 122. The storage transistor 120 comprises a floating gate 126 and a control gate 127, insulating layer 128, a source area 124, and a drain area 123, The insulating layer 128 serve to isolate the floating gate 126 and the control gate 127; the source area 124 is connected to the source line S/L; and the drain area 123 is shared with the source area 119 fo the select transistor 110 in the single doped region 122. Fig. 3 shows a circuit diagram of an equivalent circuit of the device shown in Figs. 1 and 2.

The operation of a conventional EEPROM having the above structure will now be described by describing individually its three possible operations of writing, erasing, and reading. These will be considered in the order in which they are listed.

### 1. Writing operation

In the arrangement shown in Fig. 3, voltages applied to the bit line B/L and the word line W/L are both set high enough to activate the select transistor 110. As a result, the high potential applied to the bit line B/L is transferred to the drain area of the storage transistor 120. The control gate 127 of the storage transistor 120 is then grounded and the source line S/L connected to the source area of the storage transistor 120 is left floating. This causes a tunneling phenomenon wherein electrons move into the drain area 123 of the storage transistor from the floating gate 126 via the tunnel window 121. As a result of the tunneling phenomena, the floating gate 126 is positively charged.

### 2. Erasing operation

For the erasing operation, the bit line B/L is grounded and the voltage applied to the word line W/L is made high to activate the select transistor 110. Accordingly, the low potential applied to the bit line B/L is transferred to the drain area 123 of the storage transistor 120. Then, a voltage applied to the control gate 127 of the storage transistor 120 is made high and the source line S/L connected to the source area 124 of the storage transistor 120 is left floating.

This causes a tunneling phenomenon in which electrons move to the floating gate 126 from the drain area 123 via the tunnel window 121 formed of a tunnel oxide. As a result of this tunneling phenomena, the floating gate 126 is negatively charged.

### 3. Reading operation

During a reading operation, a 5 volt driving voltage is first applied to the word line W/L to activate the select transistor 110. Then, after applying 2 to 4 volts to the bit line, the source line S/L is grounded. Afterwards, a predetermined read voltage V_{READ} is applied to the control gate 127 of the storage transistor 120. A stored data value of "1" or "0" is determined according to whether the storage transistor 120 is activated or not, i.e., whether current flows or not. The magnitude of the read voltage V_{READ} is between a first threshold voltage Vₜ₁ of the storage transistor 120 during the writing operation and a second threshold voltage Vₜ₂ of the storage transistor 120 during the erasing operation.

According to the conventional EEPROM which performs the above operations, current flowing between the source line S/L and the bit line B/L passes below the tunnel window 121 during the reading operation. This current flow causes the charged holes in the floating gate to attract the channel electrons below the tunnel window in the floating gate, or this current flow generates hot electrons in the channel region adjacent the drain area to move in the floating gate via the tunnel window, thus causing potential data reading errors. The potential for these errors increases as the number of read operation increase. As a result, when the conventional EEPROM is used in a device requiring repeated reading operations such as an IC card, the life span of the EEPROM is diminished. An additional discussion of conventional EEPROM device can be seen in "A Millin-Cycle CMOS 256K EEPROM,"by D. Coaca, et al., IEEE Journal of Solid-State Circuits, Vol. SC-22, No. 5, October 1987. The reader is directed to consider the teaching of this application in the light of this document.

EP-A-0053075 describes a nonvolatile electrically erasable and programmable read-only memory, having a cell with four transistors. A read transistor and a first-select transistor are connected in series, and a write-erase transistor and a second select transistor are likewise connected in series. The write-erase transistor has a floating gate with a thin insulating layer whereas the read transistor has a floating gate with a thick insulating layer thereunder. These floating gates are electrically connected together.

A similar arrangement is disclosed in US 4 628 487.

It is an object of the present invention to provide a nonvolatile memory device which includes a first active line, used only for a reading operation, and a second active line, used only for a writing operation placed between a bit line and a source line to improve a data retention characteristic during the reading operation, thereby increasing the number of data reading operations which can be performed without error.

According to the invention, this object is achieved by a nonvolatile memory device comprising; a bit line (B/L); a source line (S/L); a control gate (27); a first word line (W/L) and a separate second word line; a first active line including a first select transistor where the first active line crosses the first word line for selectively connecting the bit line (B/L) and the source line (S/L); wherein the first word line controls the first active line; a second active line including a second select transistor formed where the second active line crosses the second word line (W/L) insulated from the first active line and the source line (S/L), for selectively connecting the bit line (B/L) to a tunnel window (23) formed under a floating gate (26); wherein the second word line controls the second active line; and a storage transistor (12) including the floating gate formed where the first active line crosses the control gate (27), wherein the first and second active lines can be controlled separately; the first active line selectively connects the bit line (B/L) and the source line (S/L) in accordance with a word voltage applied to the first word line (W/L) and the control voltage applied to the control gate (27), and the second active line selectively connects the bit line (B/L) to the tunnel window (23) in accordance with the word voltage applied to the second word line (W/L).

The first word line in the nonvolatile memory device determines whether to activate the first select transistor and the second word line determines whether to activate the second select transistor.

Accordingly, compared with the conventional nonvolatile memory device in which writing and reading operations are performed using a single active line, the nonvolatile memory device of aspects of the present invention includes two active lines, i.e., a first active line used only for a reading operation, and a second active line used only for a writing operation. This structure prevents the movement of electrons to the floating gate during the flow of current during the reading operation. Thus, the number of data readings achievable is much higher than that for the conventional nonvolatile memory device, thereby increasing the life span of the device.

Specific embodiments of the present invention are described in detail below, by way of example, with reference to the attached drawings, in which:
Fig.1 shows a layout of a conventional nonvolatile memory device:
Fig. 2 is a cross-sectional view cut along line A-A' of Fig. 1;
Fig. 3 shows an equivalent circuit diagram of the layout shown in Fig. 1;
Fig. 4 shows a layout of a nonvolatile memory device according to a first comparative example;
Fig. 5 is a cross-sectional view cut along line B-B' of Fig. 4;
Fig. 6 is a cross-sectional view cut along line C-C' of Fig. 4;
Fig. 7 shows a layout of a nonvolatile memory device according to a comparative example;
Fig. 8 is a cross-sectional view cut along line B-B' of Fig. 7;
Fig. 9 is a cross-sectional view cut along line C-C' of Fig. 7;
Fig. 10 shows a layout of a nonvolatile memory device according to a preferred embodiment of the present invention;
Fig. 11 is a cross-sectional view cut along line B-B' of Fig. 10;
Fig. 12 is a cross-sectional view cut along line C-C' of Fig. 10;
Fig. 13 shows an equivalent circuit for the layout shown in Fig. 10;
Fig. 14 is a graph showing the relationship between channel length and cell threshold voltage in both a conventional nonvolatile memory device and in the device shown in Fig. 7;
Fig. 15 is a graph showing the relationship between channel width and cell threshold voltage in both a conventional nonvolatile memory device and in the device shown in Fig. 7;
Fig. 16 is a graph showing the relationship between channel length and cell current in both a conventional nonvolatile memory device and in the device shown in Fig. 7;
Fig. 17 is a graph showing the relationship between channel width and cell current in both a conventional nonvolatile memory device and in the device shown in Fig. 7; and
Fig. 18 is a graph showing comparatively the change of cell threshold voltage according to the read time in both a conventional nonvolatile memory device and in the device shown in Fig. 7.

A preferred embodiment of the present invention will now be described with reference to the appended drawings.

### First comparative example

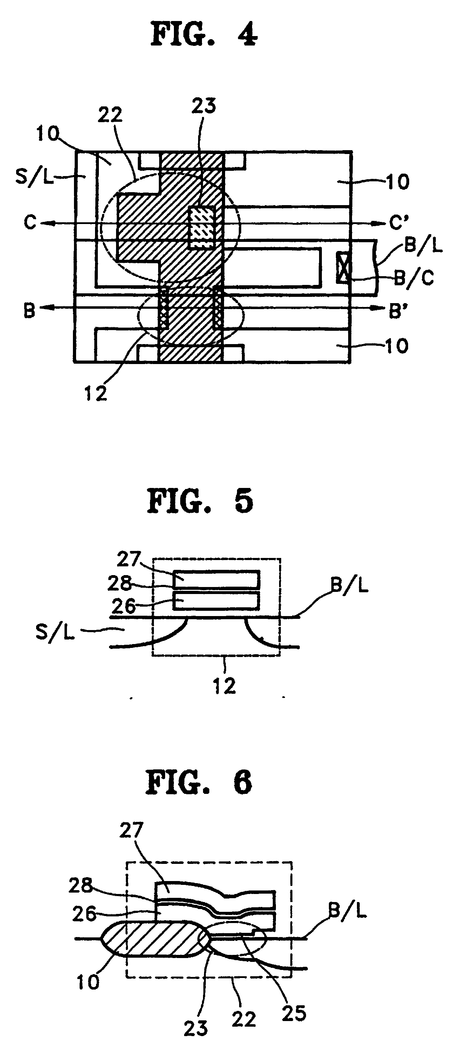

Fig. 4 shows a layout of a nonvolatile memory device according to a first comparative example of the present invention. Fig. 5 is a cross-sectional view cut along line B-B' of Fig. 4 showing a first active line. Fig. 6 is a cross-sectional view cut along line C-C' of Fig. 4 showing a second active line. In the nonvolatile memory shown in Fig. 4 to 6, a control gate 27 is place between a bit line B/L and a source line S/L and is formed in parallel with the source line S/L.

Also, a floating gate 26 having the same size as the control gate 27 is formed below the control gate 27. An insulating layer 28 is formed between the floating gate 26 and the control gate 27 to isolate the floating gate 26 and the control gate 27. A first active line and a second active line are formed between the bit line B/L and the source line S/L, such that the first active line crosses the control gate 27 and simultaneously connects the bit line B/L to the source line S/L according to the state of voltge applied to the control gate. The second active line, insulated from the first active line and the source line S/L by a field oxide layer 10, connects the bit line B/L to the tunnel window formed of tunnel oxide 25 for injecting electrons into the floating gate 26 and extracting electrons from the floating gate 26 according to the state of voltage applied to the control gate. A first storage transistor 12 is formed in the portion of the first active line where the control gate 27 is crossed by the first acive line. A tunnel window is not formed, however, at the floating gate 26 in the first storage transistor 12, A source of the first storage transistor 12 connects to the source line S/L.

A second storage transistor 22 is formed in the portion of the second active line where the control gate 27 is crossed by the second active line. The second storage transistor 22 includes a portion of the floating gate 26, which is in the same as the portion of the floating gate 26 at the first storage transistor 12. Since the second storage transistor 22 is insulated from the source line S/L by the field oxide layer 10, the second storage transistor 22 has no source area. A tunnel window 23 formed of a tunnel oxide 25 is formed between the drain of the second storage transistor 22 and the floating gate 26.

A bit line B/L is connected to the drains of the first storage transistor 12 and the second storage transistor via a bit line contact B/C.

The operation of the nonvolatile memory device according to the first comparative example having the above structure will be described by describing individually its three possible operations of writing, erasing, and reading. These will be considered in the order in which they are listed.

### 1. Writing operation

In the writing operation, the voltage applied to the bit line B/L is first made high.

When the high potential applied to the bit line B/L is transferred to the drain area of the first and second storage transistors 12 and 22, the control gate 27 is then grounded. This causes a tunneling phenomenon to occur in the tunnel window 23 formed at the floating gate 26 of the second storage transistor 22. As a result of this tunneling phenomenon, electrons move into the drain area from the floating gate 26 of the second storage transistor 22 through the tunnel window. Accordingly, the floating gate 26 is positively charged. Here, since the first storage transistor 12 of the first active line does not a tunnel window, there is no electron movement. However, since the floating gate 26 of the first storage transistor 12 of the first active line is connected to the floating gate 26 of the second storage transistor 22 of the second active line, the floating gate 26 of the first storage transistor 12 is to be in the positively charged state like the second storage transistor 22.

### 2. Erasing operation

In the erasing operation, the bit line B/L is first grounded to transfer a low potential to the drain area of the first and second storage transistors 12 and 22. Then, if the voltage applied to the control gate 27 is made high, a tunneling phenomenon occurs in which electrons in the drain area move towards the floating gate 26 of the second storage transistor 22. Accordingly, after the tunneling phenomenon the floating gate 26 is negatively charged. There is no movement of electrons in the first storage transistor 12, since the first storage transistor 12 of the first active line does not have a tunnel window. However, because the floating gate 26 of the second storage transistor 22 in the second active line is contiguous with the floating gate 26 of the first storage transistor 12 of the first active line, the floating gate 26 of the first storage transistor 12 is also in a negatively charged state after the tunneling phenomenon occurs in the second storage transistor 22.

### 3. Reading operation

In the reading operation, after applying a voltage, preferably 2 to 4 volts, to the bit line B/L, the source line S/L is grounded. A predetermined read voltage VREAD is then applied to the control gate 27. Here, a data value of "1" or "0" is determined according to whether the first storage transistor 12 is activated or not, i.e., whether the current flows through the first storage transistor 12 or not. The read voltage VREAD preferably has a level between a first threshold voltage Vₜ₁ of the first storage transistor 12 during the writing operation and a second threshold voltage Vₜ₂ of the first storage transistor 12 during the erasing operation.

### <Second comparative example>

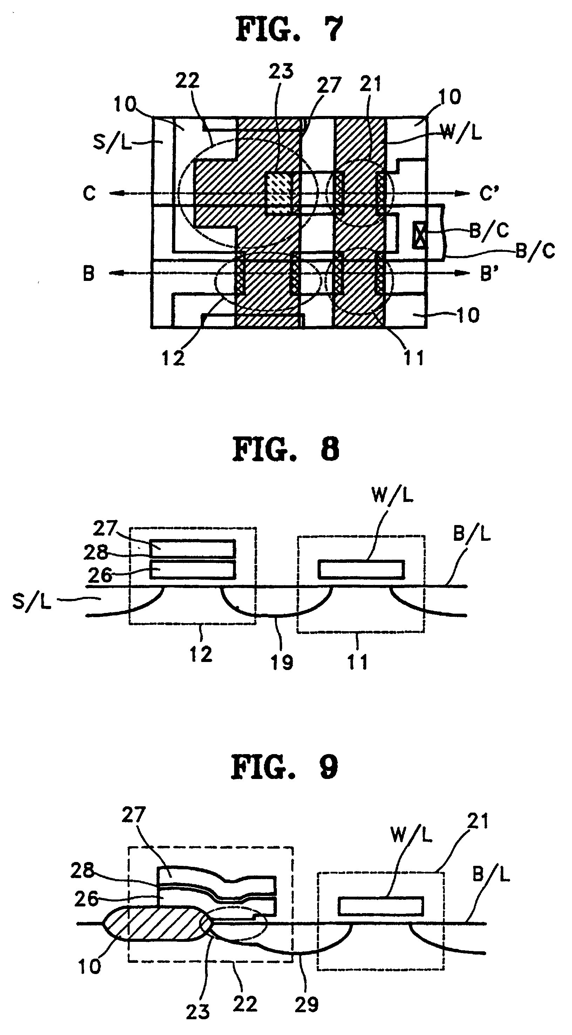

Fig. 7 is a layout of a nonvolatile memory device according to a second comparative example. Fig. 8 is a cross-sectional view cut along line B-B' of Fig. 7 showing a first active line. Fig. 9 is a cross-sectional view cut along line C-C' of Fig. 7 showing a second active line.

As shown in Figs. 7 to 9, in the nonvolatile memory device of the present invention, a word line W/L and a control gate 27 are formed in parallel between a bit line B/L and a source line S/L. A floating gate 26 having the same size as the control gate 27 is also formed below the control gate 27 and is separated from the control gate by an insulating layer 28. A first active line and a second active line are formed between the bit line B/L and the source line S/L.

The first active line crosses the word line W/L orthogonally and connects the bit line B/L with the source line S/L according to the state of the applied voltage of the control gate 27. The second active line connects the bit line B/L to a tunnel window 23 formed of a tunnel oxide for injecting electrons into the floating gate 26 and extracting electrons from the floating gate 26 according to the applied voltage state of the control gate 27. The second active line is insulated from the first active line and the source line S/L by a field oxide layer 10.

As shown in Figs. 7 and 8, the first active line has a first select transistor 11, a first storage transistor 12, and a common doped region 19 shared by the two transistors. Here, common doped region 19 is the drain of the first storage transistor 11 and also is the source of the first select transistor 12. The first select transistor 11 is formed in the portion of the first active line wherein the first active line is crossed by the word line W/L, and the first storage transistor is formed in the portion of the first active line wherein the first active line is crossed by the control gate 27 enhancement mode NMOS transistor. The first storage transistor 12 does not include a tunnel window, and a source of the first storage transistor connects to the source line S/L.

As shown in Figs. 7 and 9, the second active line has a second select transistor 21, a second storage transistor 22, and a common doped region 29 shared by the two transistors. Here, common doped region 19 is the drain of the second storage transistor 21 and also is the source of the second select transistor 22. The second select transistor 21 is formed at a portion of the second active line where the second active line is crossed by the word line W/L. The second storage transistor 22 is formed at a portion of the second active line where the second active line is crossed by the control gate 27. This second storage transistor 22 has a floating gate 26 contiguous with the floating gate 26 of the first storage transistor 12. This means that the floating gate 26 in the second storage transistor 22 is in the same state as the floating gate 26 in the first storage transistor 12. The second select transistor 21 comprises a channel enhancement mode NMOS transistor. The second storage transistor 22 has no source area due to the insulation of the source line S/L by the field oxide layer 10. A tunnel window 23 formed of a tunnel oxide 25 is formed under the floating gate 26 of the second storage transistor 22.

A bit line B/L is connected to the drains of the select transistor and the second transistor. The operation of a nonvolatile memory device according to the second comparative example having the above structure will be described by describing of the present invention having the above structure will be described by describing individually its three possible operations of writing, erasing, and reading. These will be considered in the order in which they are listed.

### 1. Writing operation

During the writing operation, a voltage applied to the bit line B/L is first made high. Then if the voltage applied to the word line W/L is made high, the first and second select transistors 11 and 12 are activated so that the high potential applied to the bit line B/L is transferred to the drain area of the first and second storage transistor 12 and 22, i.e., to the doped areas 19 and 29, respectively. When the control gate 27 is grounded, a tunneling phenomenon occurs at the tunnel window 23 formed in the floating gate 26 of the second storage transistor 22.

This tunneling phenomenon causes electrons to move into the drain from the floating gate 26 of the second storage transistor 22, positively charging the floating gate 26. Since the first storage transistor 12 of the first active line does not include a tunnel window, there is no electron movement in the first storage transistor 12. However, since the floating gate 26 of the second storage transistor 22 of the second active line is contiguous with the floating gate 26 of the first storage transistor 12, the floating gate 26 of the first storage transistor 12 achieves a positively charged state after the tunneling phenomenon.

### 2. Erasing operation

In the erasing operation, the bit line B/L is first grounded and the voltage applied to the word line W/L is made high to make active the first and second select transistors 11 and 21, so that the low potential applied to the bit line B/L is transferred to the drain area of the first and second storage transistors 12 and 22. When the voltage applied to the control gate 27 is made high, a tunneling phenomenon occurs at the tunneling window 23.

This tunneling phenomeon causes the tunneling of electrons from the drain area in the doped region 29 to the floating gate 26 of the second storage transistor 22, thus negatively charging the floating gate 26. Since the first storage transistor 12 of the first active line does not include a tunnel window, there is no electron movement in the first storage transistor 12.

However, since the floating gate 26 of the second storage transistor 22 of the second active line is contiguous with the floating gate 26 of the first storage transistor 12, the floating gate 26 of transistor 12 achieves the negatively charged state after the tunneling phenomenon.

### 3. Reading operation

During the reading operation, a driving voltage, preferably 5 volts, is first applied to the word line W/L to make active the first and second select transistors 11 and 21, a voltage, preferably 2 to 4 volts, is applied to the bit line B/L, and the source line S/L is grounded.

A predetermined read voltage VREAD is then applied to the control gate. The data value of "1" or "0" is determined according to whether the first storage transistor 12 is activated or not, i. e., whether current flows through the first storage transistor 12 or not. The read voltage VREAD preferably has a level between a first threshold voltage Vₜ₁ of the first storage transistor 12 during the writing operation and a second threshold voltage Vₜ₂ of the first storage transistor 12 during the erasing operation.

### <preferred embodiment>

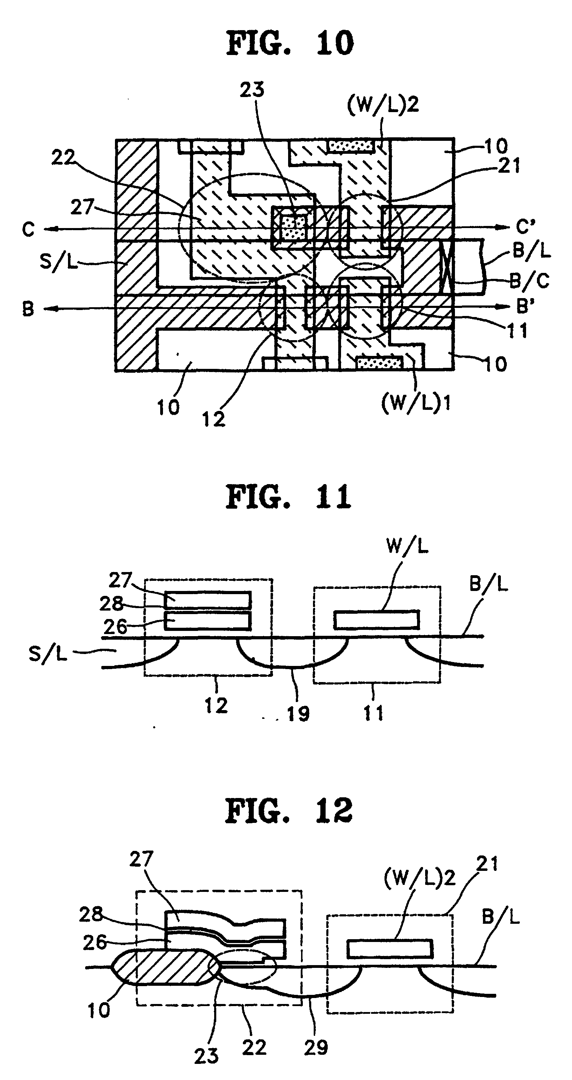

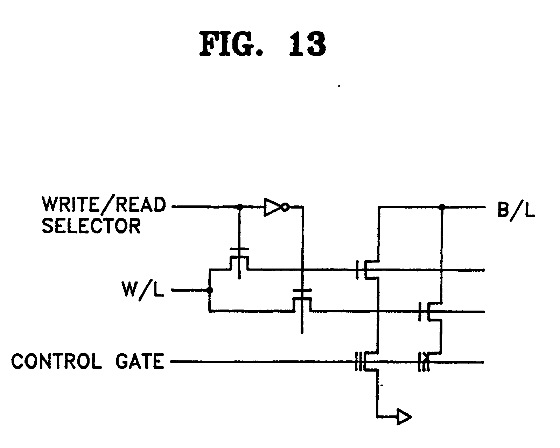

Fig. 10 is a layout of a nonvolatile memory device according to a preferred embodiment of the present invention. Fig. 11 is a cross-sectional view along line B-B' of Fig. 10 showing a first active line. Fig 12 is a cross-sectional view cut along line C-C' of Fig. 10 showing a second active line. Fig. 13 is an equivalent circuit diagram of the layout shown in Fig. 10.

As shown in Fig. 10, the nonvolatile memory device of this embodiment is similar to the device of the second preferred embodiment, except that the third preferred embodiment has two separate word lines(W/L)₁ and (W/L)₂ . Elements shown in Fig. 10 to 12 are substantially the same as comparable elements shown in Figs. 7 to 9. The following discussion will limit itself to areas where the second and the third preferred embodiments differ.

In the preferred embodiment, the first word line(W/L)₁ determines whether to activate the first select transistor 11 of the first active line, and the second word line (W/L)₂ determines whether to activate the second select transistor 21 of the second active line. These two word lines divide the functions of a single word line W/L, like the word line shown in Fig 7 with reference to the second comparative example. In the preferred embodiment, however, unlike the second comparative example, the first and second active lines can be controlled separately, so that the current flowing into second active line via the bit line can be blocked completely during the reading operation.

The operation of a nonvolatile memory device according to the preferred embodiment of the present invention having the above structure will be described by describing individually its three possible of writing, erasing, and reading. These will be considered in the order in which they are listed.

### 1. Writing operation

In the writing operation, a voltage applied to the bit line B/L is first made high. Then, if the voltage applied to the first word line (W/L)₁ is made low and the voltage applied to the second word line(W/L)₂ is made high this indicates a writing operation. In this case, the first select transistor 11 is deactivated, the second select transistor 21 is activated, and the high potential applied to the bit line B/L is transferred to the drain area of the second storage transistor 22. If the control gate 27 is grounded, a tunneling phenomenon occurs at the tunnel window 23 formed in the floating gate 26 of the second storage transistor 22. This tunneling effect causes electrons to move into the drain area in a doped region 29 from the floating gate 26 of the second storage transistor 22, positively charging the floating gate 26.

Since the first storage transistor 12 of the first active line does not include a tunnel window and the first select transistor 11 is turned off, there is no electron movement in the first storage transistor 12. However, since the floating gate 26 of the second storage transistor 22 of the second active line is contiguous with the floating gate 26 of the first storage transistor 12, the floating gate 26 of the first storage transistor 12 achieves a positively charged state after the tunneling phenomenon.

### 2. Erasing operation

During the erasing operation, when the bit line B/L is grounded, a voltage applied to the first word line (W/L)₁ is first made low and a voltage applied to the second word line (W/L)₂ is made high, indicating an erasing operation. In this case, the first select transitor 11 is deactivated, the second select transistor 21 is actived, and the low potential applied to the bit line B/L is transferred to the drain area of the second storage transistor 22. If the voltage applied to the control gate 27 is then made high, a tunneling phenomenon occurs causing electrons to move from the drain area in the doped region 29 to the floating gate 26 of the second storage transistor 22, negatively charging the floating gate 26.

Since the first storage transistor 12 fo the first active line does not include a tunnel window and the first select transistor is turned off, there is no electron movement in the first storage transistor. However, since the floating gate 26 the second storage transistor 22 of the second active line is contiguous with the floating gate 26 of the first storage transistor 12, the floating gate 26 fo the first storage transistor 12 is likewise set to a negatively charged state after the tunneling phenomenon.

### 3. Reading operation

In the reading operation, when a voltage applied to the first word line (W/L) becomes high and the voltage applied to the second word line (W/L) becomes low the first select transistor 11 is turned on so that the first storage transistor 12 is connected to the bit line B/L, but the second select transistor 21 is turned off so that the tunnel window of the first transistor 22 is disconnected from the bit line B/L. A voltage, preferably 2 to 4 volts, is then applied to the bit line B/L and the source line S/L is grounded.

A predetermined read voltage VREAD is then applied to the control gate 27. The data value of "1" or "0" is determined according to whether the first storage transistor 12 is activated or not, i. e., whether current flows through the first threshold voltage Vₜ₁ of the first storage transistor 12 during the writing operation and a second threshold voltage Vₜ₂ of the first storage transistor 12 during the erasing operation. Current does not flow in the second active line due to the deactivation of the second select transistor 21. As a result of this, the state of the floating gate 26 does not change at all during a read operation.

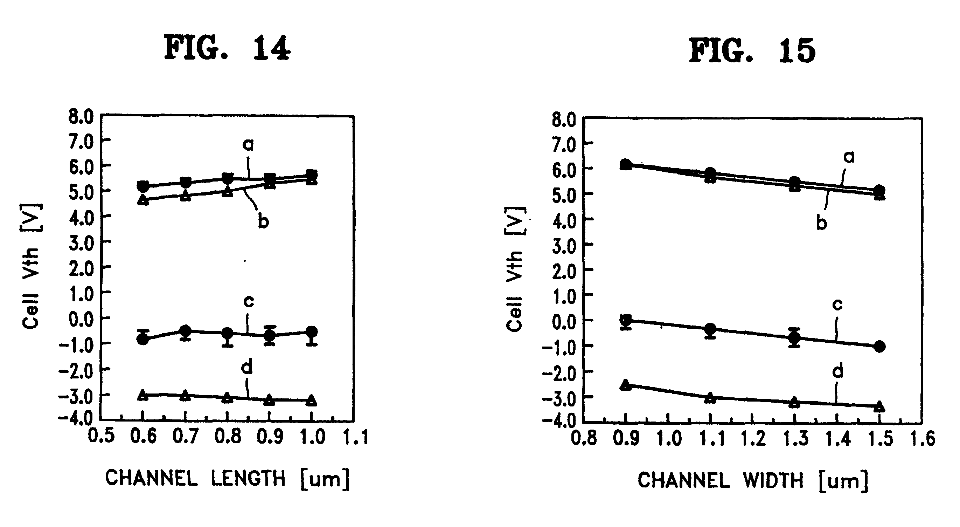

Characteristics of the nonvolatile device of the second comparative example were evaluated by experiment, and the results shown in Figs. 14 to 17 were obtained.

Fig. 14 is a graph showing the relationship between channel length and cell threshold voltage. In Fig. 14, line "a" represents the cell threshold voltage of a conventional nonvolatile memory device during the erasing operation, line "b" represents the cell threshold voltage of the nonvolatile memory device of the second preferred embodiment of the present invention during the erasing operation ; line "c" represents the cell threshold voltage of a conventional nonvolatile memory device during the writing operation; and line "d" represents the cell threshold voltage of the nonvolatile memory device of the second comparative example of the present invention during the writing operation.

As can be seen in Fig. 14, the cell transistor voltage to the channel length of the nonvolatile memory device of the present invention is lower than that of the conventional nonvolatile memory device by more than 2 volts during the writing operation.

Fig. 15 is a graph showing the relationship between channel width and cell threshold voltage. In Fig. 15, line "a" represents the cell threshold voltage of a conventional nonvolatile memory device during the erasing operation; line "b" represents the cell threshold voltage of the nonvolatile memory device of the second preferred embodiment of the present invention during the erasing operation; line "c" represents the cell threshold voltage of conventional nonvolatile memory device during the writing operation; and line "d" represents the cell threshold voltage of the nonvolatile memory device of the second preferred embodiment of the present invention during the writing operation.

As can be seen in Fig. 15, the cell transistor voltage compared to the channel width does not differ between the nonvolatile memory device of the present invention and the conventional nonvolatile memory device during the erasing operation. However, the cell transistor voltage to the channel width of the nonvolatile memory device of the present invention is at least two volts lower than that of the conventional nonvolatile memory device during the writing operation.

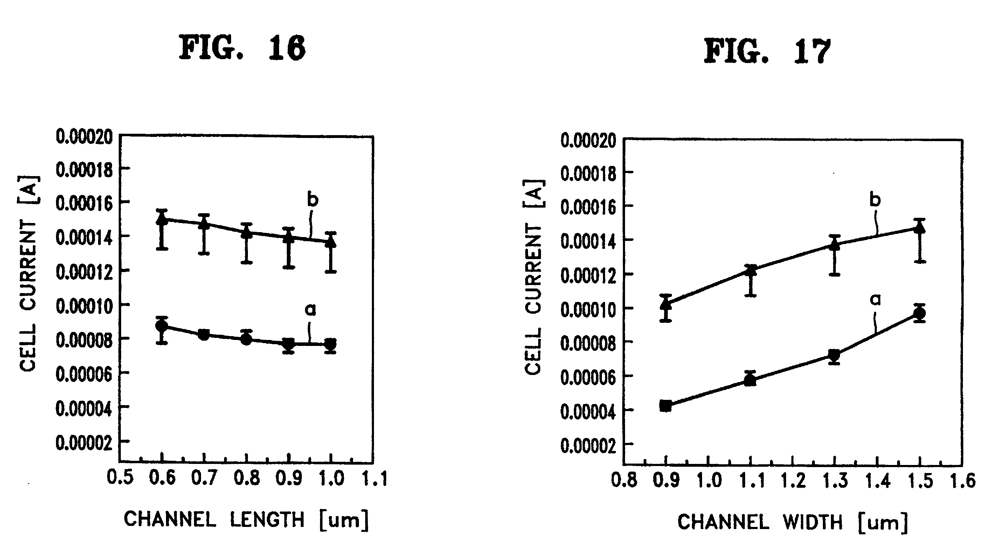

Fig. 16 is a graph showing the relationship between channel length and cell current.

In Fig. 16, line "a" represents the cell current of a conventional nonvolatile memory device and line "b" represents the cell current of the nonvolatile memory device of the second preferred embodiment of the present invention.

Fig. 17 is a graph showing the relationship between channel width and current. In Fig. 17, lines "a" and "b" represent the cell current of a conventional nonvolatile memory device and the nonvolatile memory device of the second preferred embodiment of the present invention, respectively.

As shown from Figs. 16 and 17, the cell current to the channel width is higher in the nonvolatile memory device of the present invention than in the conventional nonvolatile memory device. In other words, the nonvolatile memory device has lower threshold voltage and higher cell current than the conventional nonvolatile memory device during the writing operation, so that improved precision in reading as well as improved speed can be obtained during the reading operation.

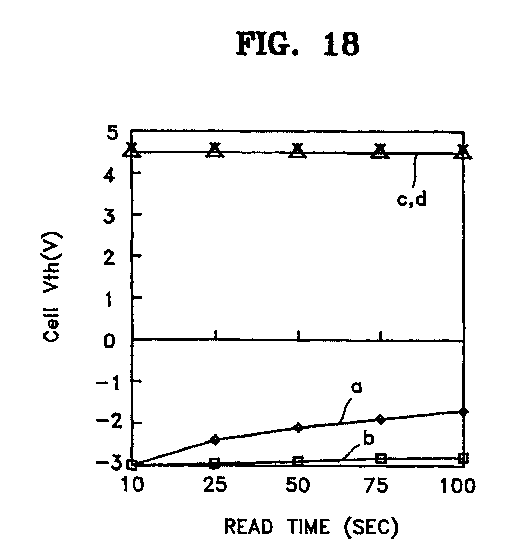

Fig. 18 is a graph showing comparatively the change of cell threshold voltage according to read time in the conventional nonvolatile memory device and the nonvolatile memory device according to the present invention. In Fig. 18, line "a" and line "c" (with triangles) represent the change of the cell threshold voltage when the states.of the applied voltage are "1" and "o", respectively; and line "b" and line "d"(with crosses) represent the change of the cell threshold voltage of the nonvolatile memory device of the second preferred embodiment of the present invention when the states of the applied voltage are "1" and "o", respectively.

As shown in Fig. 18, the nonvolatile memory device of the present invention has extremely small variation of cell threshold voltage with many repeated numbers of reading operations compared to the conventional nonvolatile memory device. This small variation means that the device in accordance with the second preferred embodiment of the present invention provides excellent cell retention time characteristics as compared with conventional devices.

As described above, the nonvolatile memory device of the present invention performs reading and writing operations using different active lines. Since the active line for the reading operation does not have a tunnel window, data error caused by repeated reading operations is prevented, thereby lengthening the life span of the device. Particularly, when the word lines are separated into different active lines as shown in the preferred embodiment, the current flow into the second active line is completely blocked during the reading operation, thereby further improving data retention characteristics during the reading operation.

The present invention is not limited to the above-described embodiments. Various changes and modifications may be effected by one having an ordinary skill in the art and remain within the scope of the invention, as defined by the appended claims.

## Claims

1. A nonvolatile memory device comprising;
a bit line (B/L);
a source line (S/L);
a control gate (27);
a first word line (W/L) and a separate second word line;
a first active line including a first select transistor where the first active line crosses the first word line for selectively connecting the bit line (B/L) and the source line (S/L); wherein the first word line controls the first active line;
a second active line including a second select transistor formed where the second active line crosses the second word line (W/L) insulated from the first active line and the source line (S/L), for selectively connecting the bit line (B/L) to a tunnel window (23) formed under a floating gate (26); wherein the second word line controls the second active line; and
a storage transistor (12) including the floating gate formed where the first active line crosses the control gate (27), wherein the first and second active lines can be controlled separately; the first active line selectively connects the bit line (B/L) and the source line (S/L) in accordance with a word voltage applied to the first word line (W/L) and the control voltage applied to the control gate (27), and the second active line selectively connects the bit line (B/L) to the tunnel window (23) in accordance with the word voltage applied to the second word line (W/L).

2. The nonvolatile memory device as claimed in claim 1 wherein the first word line determines whether to activate the first select transistor (11) and the second word line determines whether to activate the second select transistor (21).

## Patentansprüche

1. Nichtflüchtige Speicheranordnung umfassend:
eine Bitleitung (B/L);
eine Sourceleitung (S/L);
ein Steuergate (27);
eine erste Wortleitung (W/L) und eine separate zweite Wortleitung;
eine erste aktive Leitung mit einem ersten Selektiertransistor, wo die erste aktive Leitung die erste Wortleitung kreuzt, um die Bitleitung (B/L) und die Sourceleitung (S/L) selektiv zu verbinden; worin die erste Wortleitung die erste aktive Leitung steuert;
eine zweite aktive Leitung mit einem zweiten Selektiertransistor, der ausgebildet. ist, wo die zweite aktive Leitung die zweite Wortleitung (W/L) kreuzt, isoliert von der ersten aktiven Leitung und der Sourceleitung (S/L), um die Bitleitung (B/L) mit einem unter einem schwebenden Gate (26) ausgebildeten Turinelfenster (23) selektiv zu verbinden; worin die zweite Wortleitung die zweite aktive Leitung steuert; und
einen Speichertransistor (12) mit dem schwebenden Gate, das ausgebildet ist, wo die erste aktive Leitung das Steuergate (27) kreuzt, worin die erste und zweite aktive Leitung separat gesteuert werden können; die erste aktive Leitung die Bitleitung (B/L) und die Sourceleitung (S/L) gemäss einer auf die erste Wortleitung (W/L) aufgebrachten Wortspannung und auf das Steuergate (27) aufgebrachten Steuerspannung selektiv verbindet, und die zweite aktive Leitung die Bitleitung (B/L) mit dem Tunnelfenster (23) gemäss der auf die zweite Wortleitung (W/L) aufgebrachten Wortspannung selektiv verbindet.

2. Nichtflüchtige Speicheranordnung nach Anspruch 1, worin die erste Wortleitung bestimmt, ob der erste Selektiertransistor (11) zu aktivieren ist und die zweite Wortleitung bestimmt, ob der zweite Selektiertransistor (21) zu aktivieren ist.

## Revendications

1. Dispositif de mémoire non-volatile comprenant :
une ligne de bits(B/L) ;
une ligne de source (S/L) ;
une grille de commande (27) ;
une première ligne de mots (W/L) et une seconde ligne de mots séparée ;
une première ligne active comportant un premier transistor de séléction où la première ligne active croise la première ligne de mots pour connecter de façon sélective la ligne de bits (B/L) et la ligne de source (S/L) ; où la première ligne de mots commande la première ligne active ;
une seconde ligne active comportant un second transistor de sélection formé où la seconde ligne active croise la seconde ligne de mots (W/L), isolée de la première ligne active et de la ligne de source (S/L) pour connecter de façon sélective la ligne de bits (B/L) à une fenêtre tunnel (23) formée sous la grille flottante (26) ; où la seconde ligne de mots commande la seconde ligne active ; et
un transistor de stockage (12) comportant la grille flottante formée où la première ligne active croise la grille de commande (27), où les première et seconde lignes actives peuvent être commandées séparément ; la première ligne active connecte de façon sélective la ligne de bits (B/L) et la ligne de source (S/L) en fonction d'une tension de mot appliquée à la première ligne de mots (W/L) et de la tension de commandé appliquée à la grille de commande (27) et la seconde ligne active connecte de façon sélective la ligne de bits (B/L) à la fenêtre tunnel (23) en fonction de la tension de commande appliquée à la seconde ligne de mots (W/L).

2. Dispositif de mémoire non-volatile selon la revendication 1, dans lequel la première ligne de mots détermine s'il faut activer le premier transistor de sélection (11) et la seconde ligne de mots détermine s'il faut activer le second transistor de sélection (21).
